**Europäisches Patentamt**

**European Patent Office**

**Office européen des brevets**

(11) Veröffentlichungsnummer: **0 313 555**
**B1**

(12) **EUROPÄISCHE PATENTSCHRIFT**

(45) Veröffentlichungstag der Patentschrift: **14.11.90**

(51) Int. Cl.⁵: **H 01 L 25/07**

(21) Anmeldenummer: **87903241.5**

(22) Anmeldetag: **15.05.87**

(86) Internationale Anmeldenummer:
**PCT/DE87/00226**

(87) Internationale Veröffentlichungsnummer:
**WO 88/00395 14.01.88 Gazette 88/02**

(54) **STAPELFÖRMIGE DIODENANORDNUNG MIT HOHER SPANNUNGSFESTIGKEIT.**

(30) Priorität: **30.06.86 DE 3621929**

(43) Veröffentlichungstag der Anmeldung:
**03.05.89 Patentblatt 89/18**

(45) Bekanntmachung des Hinweises auf die
Patenterteilung:
**14.11.90 Patentblatt 90/46**

(84) Benannte Vertragsstaaten:
**DE FR GB IT NL**

(56) Entgegenhaltungen:
**US-A-3 736 475**
**US-A-3 886 581**

(73) Patentinhaber: **ROBERT BOSCH GMBH**
**Postfach 50**
**D-7000 Stuttgart 1 (DE)**

(72) Erfinder: **WALLRAUCH, Alexander**
**Keplerstr. 14**
**D-7413 Gomaringen (DE)**
Erfinder: **IVANUSEC, Mirjana**
**Hans-Reyhingstr. 17**
**D-7410 Reutlingen (DE)**
Erfinder: **HEYKE, Klaus**
**Bodäckerstr. 23**
**D-7410 Reutlingen (DE)**
Erfinder: **MEINDERS, Horst**
**Kammweg 54**
**D-7410 Reutlingen (DE)**

Courier Press, Leamington Spa, England.

## Beschreibung

### Stand der Technik

Die Erfindung betrifft eine stapelförmige Diodenanordnung mit hoher Spannungsfestigkeit gemäß Oberbegriff des Hauptanspruchs. Eine derartige Diodenanordnung ist aus US-A-3736475 bekannt.

Hochspannungsdioden mit einer Spannungsfestigkeit von 10—60 kV werden für Fernsehschaltungen, aber auch in der Kraftfahrzeugtechnik für die verteilerlose Zündung zum direkten Einbau in die Zündspule verwendet. Da es unmöglich ist, eine einzige Diode monolithisch mit dieser Sperrfähigkeit auf kleinem Raum herzustellen, hat sich die Stapeldiode, also die Aufschichtung mehrerer flächengleicher Dioden zu einem Diodenstäbchen, als günstigste Lösung erwiesen.

Zur Herstellung dieser Diodenstapel werden Halbleiterdiodenscheiben aus n-Silizium mit einer ganzflächig eindiffundierten p-Zone beidseitig mit Aluminium bedampft, aufeinandergestapelt, das Scheibenpaket mit einem Gewicht beschwert und auf eine solche Temperatur gebracht, daß die angrenzenden Aluminiumschichten der Diodenscheiben miteinander verschmelzen. Anschließend werden stabförmige Anordnungen (Diodenstäbe) mit einer Diamantensäge in dem benötigten Maß ausgesägt. An die Anode und Kathode dieser stäbchenförmigen Diodenstapel müssen nun mit einem weiteren Lötvorgang Kopfdrähte angebracht werden. Da der Diodenstapel seine volle Sperrfähigkeit erst dann erlangt, wenn die einzelnen pn-Übergänge mit einer Siliziumätze sauber geätzt sind, ergibt sich das Problem, daß die Kopfdrahtmetalle im allgemeinen nicht beständig gegen diese Siliziumätze sind, weshalb sich beträchtliche Herstellungsschwierigkeiten ergeben. Zur Passivierung der saubergeätzten pn-Übergänge muß der Diodenstapel anschließend mit Glas oder einem spannungsfesten Polyimidlack abgedeckt und ausgeheizt werden.

Bei den bekannten Diodenanordnungen erfordern die Diodenkopfdrähte eine zusätzliche Lötung, das Material der Kopfdrähte ist im allgemeinen nicht gegen die Siliziumätze resistent und die Verwendung von Stapeldioden mit zwei Kopfdrähten ergibt eine Diodenanordnung, deren mechanische Festigkeit nicht besonders hoch ist.

### Vorteile der Erfindung

Die Diodenanordnung mit den Merkmalen des Hauptanspruchs hat demgegenüber den Vorteil, daß keine Kopfdrähte mehr erforderlich sind, wodurch sich das Herstellungverfahren vereinfacht und eine hohe mechanische Stabilität erzielt wird. An den Enden des Diodenstapels sind mit Kontaktschichten versehene niederohmige Scheiben angeordnet, die vorzugsweise aus Halbleitermaterial bestehen und eine Leitfähigkeit von 1—10 mohmcm haben können. Diese Scheiben sind beispielsweise 2—3 mm dick und sind in gleicher Weise wie die dazwischen angeordneten Diodenscheibchen mit diesen durch Verlöten verbunden. Der Diodenstapel wird an den stirnseitigen Scheiben mit einem elektrisch leitenden Kleber auf die Leiterbahnen eines Keramikträgers aufgeklebt, wodurch ein guter elektrischer Übergang und eine hohe Stabilität erzielt werden.

Als niederohmige Scheiben können mehrere Millimeter dicke n- oder p-Siliziumplatten verwendet werden, deren stirnseitige Kontaktschichten ebenso wie die Kontaktschichten der einzelnen Diodenscheiben aus Aluminium bestehen, so daß der gesamte Stapel einschließlich der niederohmigen Scheiben in einem Arbeitsgang miteinander an den angrenzenden Aluminiumschichten verlötet werden kann.

Zur Erhöhung der Leitfähigkeit im stirnseitigen Kontaktbereich kann die Stirnseite des Diodenstapels zusätzlich mit einer Nickel- und Gold-Oberfläche versehen sein.

Der den Diodenstapel aufnehmende Keramikkörper hat im Bereich des Diodenstapels eine Aussparung, so daß der Diodenstapel nur mit den beiden Enden auf den Leiterbahnen des Keramikkörpers aufliegt. Die Aussparung ermöglicht es, daß nach dem Festkleben des Diodenstapels ein den gesamten Diodenstapel umschließender Passivierungslack aufgebracht werden kann. Der passivierungslack und der Kleber werden anschließend gemeinsam ausgehärtet, weshalb sowohl der Passivierungslack als auch der Kleber eine im wesentlichen gleiche Aushärtetemperatur haben sollten. Es haben sich hierfür als geeignet erwiesen ein Kleber auf Epoxidharzbasis und ein Passivierungslack auf Polyimidbasis, wobei der Kleber eine Ausheiztemperatur von 260°C und der Polyimidlack eine Ausheiztemperatur von 270°C haben kann.

Die niederohmige Scheibe kann grundsätzlich auch aus Metall, beispielsweise aus Molybdän bestehen.

### Zeichnung

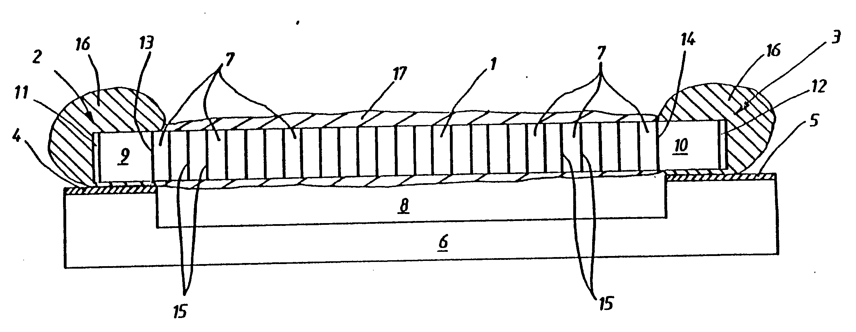

Die Erfindung wird nachfolgend anhand der Zeichnung näher erläutert, die eine Diodenanordnung im Querschnitt zeigt.

Ein Diodenstapel 1 liegt mit seinen beiden Enden 2, 3 auf Metallisierungsbahnen 4, 5 eines Keramikkörpers 6 auf. Unterhalb der stapelförmig angeordneten Dioden 7 besitzt der Keramikkörper 6 eine Aussparung 8.

An den Enden 2, 3 sind niederohmige Halbleiterscheiben 9, 10 als elektrische Anschlußelemente angeordnet, von denen das eine als Anschlußelement für die Anode und das andere als Anschlußelement für die Kathode des Diodenstapels 1 dient. Die freien Stirnseiten der Halbleiterscheiben 9, 10 sind mit Kontaktflächen 11, 12 versehen. Ebenso besitzen die dem Diodenstapel 1 zugewandten Flächen Kontaktflächen 13, 14. Sämtliche zwischen und an den einzelnen Dioden 7 angrenzenden Kontaktflächen 13, 14, 15 sind miteinander während eines gemeinsamen Lötvorgangs verlötet.

Die elektrische und mechanische Verbindung im Bereich der Enden 2, 3 erfolgt mittels eines elektrisch leitenden Klebers 16, der jeweils die Kontaktflächen 11, 12 und die Halbleiterscheiben 9, 10 und wenigstens einen Teil der jeweils zugehörigen Metallisierungsbahnen 5 überdeckt. Auf diese Weise wird eine sichere und niederohmige Kontaktierung des Diodenstapels erzielt.

Die übrige Umfangsfläche des Diodenstapels 2 ist von einem Passivierungslack 17 umgeben, der gemeinsam mit dem Kleber 16 durch Wärmeinwirkung ausgehärtet wird. Der Passivierungslack 17 wird nach dem Aufbringen des Klebers 16 auf die noch freiliegenden pn-Übergänge des Diodenstapels 1 aufgetragen. Der Passivierungslack 17 kann wegen der Aussparung 8 den Diodenstapel 1 vollständig umschließen

**Patentansprüche**

1. Diodenanordnung, bestehend aus einer Vielzahl gleichsinnig zueinander in Reihe geschalteter, flächengleicher, zu einem Diodenstapel (1) aufgeschichteter Dioden (7) und aus einem den Diodenstapel (1) tragenden Tragkörper (6) aus elektrisch isolierendem Material, bei der der Diodenstapel (1) an seinen beiden als Kathode bzw. Anode dienenden Enden (2, 3) jeweils mit einem niederohmigen Kontaktstück (9, 10) versehen ist, wobei die beiden Kontaktstücke (9, 10) auf zugehörigen Metallisierungsbahnen (4, 5) des Tragkörpers (6) aufliegen und elektrisch leitend mit diesen verbunden sind und wobei ferner der Tragkörper (6) im Bereich des Diodenstapels (1) eine Aussparung (8) hat, so daß der Diodenstapel (1) nur mittels der beiden stirnseitig an ihm angebrachten Kontaktstücke (9, 10) mit dem Tragkörper (6) Verbindung hat, dadurch gekennzeichnet, daß die elektrisch leitende Verbindung zwischen den beiden an dem Diodenstapel (1) angebrachten Kontaktstücken (9, 10) und den zugehörigen Metallisierungsbahnen (4, 5) des Tragkörpers (6) durch einen sich zwischen diesen Teilen (9 und 4 bzw. 10 und 5) erstreckenden elektrisch leitenden Kleber (16) gebildet ist und daß der Diodenstapel (1) von einem Passivierungslack (17) umschlossen ist, dessen Ausheiztemperatur wenigstens annähernd gleich der Ausheiztemperatur des elektrisch leitenden Klebers (16) ist.

2. Diodenanordnung nach Anspruch 1, dadurch gekennzeichnet, daß der elektrisch leitende Kleber (16) sich über den Auflagebereich der Kontaktstücke (9, 10) hinaus über die gesamte Oberfläche der Kontaktstücke (9, 10) mit Ausnahme der dem Diodenstapel (1) zugewandten Stirnfläche erstreckt, über die die Kontaktstücke (9, 10) mit dem Diodenstapel (1) elektrisch leitend verbunden sind.

3. Diodenanordnung nach Anspruch 1 oder 2, dadurch gekennzeichnet daß die dem Diodenstapel (1) zugewandte Stirnfläche und die dieser gegenüberliegende Stirnfläche der Kontaktstücke (9, 10) jeweils eine Metallisierung (11, 13; 12, 14) tragen.

4. Diodenanordnung nach einem der Ansprüche 1 bis 3, dadurch gekennzeichnet, daß als niederohmige Kontaktstücke (9, 10) mehrere Millimeter dicke n-oder p-Siliziumstücke verwendet werden und daß die Metallisierungen (11, 13; 12. 14) aus Aluminium bestehen.

5. Diodenanordnung nach einem der vorhergehenden Ansprüche, dadurch gekennzeichnet, daß die Stirnseiten (13, 14) des Diodenstapels (1) zusätzlich mit einer Nickel- und einer Goldschicht versehen sind.

6. Diodenanordnung nach einem der vorhergehenden Ansprüche, dadurch gekennzeichnet, daß die niederohmigen Kontaktstücke (9, 10) und der Diodenstapel (1) durch Verlöten miteinander verbunden sind.

7. Diodenanordnung nach einem der Ansprüche 1, 2, 3, 5 und 6, dadurch gekennzeichnet, daß die niederohmigen Kontaktstücke (9, 10) aus Metall, beispielsweise aus Molybdän, bestehen.

**Revendications**

1. Disposition de diodes constituée par une pluralité de diodes (7) de même surface, branchées en série dans le même sens les unes par rapport aux autres, et empilées par couches pour constituer un empilement de diodes (1), et par un corps porteur (6) en un matériau électriquement isolant supportant l'empilement de diodes (1), disposition de diodes dans laquelle, l'empilement de diodes (1) est respectivement muni à ses deux extrémités (2, 3), servant de cathode ou d'anode, d'une pièce de contact (9, 10) de basse résistance ohmique, les deux pièces de contact (9, 10) s'appliquant sur des pistes de métallisation correspondantes (4, 5) du corps porteur (6) et étant reliées à ces pistes de façon électriquement conductrice, tandis qu'en outre, le corps porteur (6) comporte un évidement (8) dans la zone de l'empilement de diodes (1), de sorte que cet empilement de diodes (1) n'a de liaison avec le corps porteur (6) que par les deux pièces de contact (9, 10) rapportées à ses côtés frontaux, disposition de diodes caractérisée en ce que la liaison électriquement conductrice, entre les deux pièces de contact (9, 10) rapportées sur l'empilement de diodes (1) et les pistes de métallisation correspondantes (4, 5) du corps porteur (6) est réalisée par une colle électriquement conductrice (16) s'étendant entre ces différentes parties (9 et 4 ou bien 10 et 5), et en ce que l'empilement de diodes (1) est entouré par une laque de passivation (17) dont la température de durcissement est au moins approximativement la même que la température de durcissement de la colle électriquement conductrice (16).

2. Disposition de diodes selon la revendication 1, caractérisée en ce que la colle électriquement conductrice (16) s'étend au-delà de la zone d'appui des pièces de contact (9, 10) sur la surface totale de ces pièces de contact (9, 10) à l'exception des surfaces frontales tournées vers l'empilement des diodes (1), par l'intermédiaire desquelles les pièces de contact (9, 10) sont reliées de façon électriquement conductrice à l'empilement des diodes (1).

3. Disposition de diodes selon la revendication 1 ou la revendication 2, caractérisée en ce que les surfaces frontales tournées vers l'empilement des diodes (1) et les surfaces frontales opposées à celles-ci des pièces de contact (9, 10) portent respectivement une métallisation (11, 13; 12, 14).

4. Disposition de diodes selon une des revendications 1 à 3, caractérisée en ce que, en tant que pièces de contact à basse résistance ohmique (9, 10) on utilise des pièces de silicium n ou p de plusieurs millimètres d'épaisseur et que les métallisations (11, 13; 12, 14) sont en aluminium.

5. Disposition de diodes selon une des précédentes revendications, caractérisée en ce que les faces frontales (13, 14) de l'empilement de diodes (1) sont munies en outre, d'une couche de nickel et d'une couche d'or.

6. Disposition de diodes selon une des précédentes revendications, caractérisée en ce que les pièces de contact à basse résistance ohmique (9, 10) et l'empilement de diodes (1) sont reliés ensemble par brasage.

7. Disposition de diodes selon une des revendications 1, 2, 3, 5 et 6, caractérisée en ce que les pièces de contact à basse résistance ohmique (9, 10) sont en métal, par exemple en molybdène.

**Claims**

1. Diode arrangement consisting of a plurality of diodes (7) of identical area and connected in series with one another in the same direction which are stacked together to form a diode stack (1), and of a support body (6) of electrically insulating material which carries the diode stack (1), in which arrangement the diode stack (1) is provided at its two ends (2, 3) used as cathode or anode, respectively, in each case with a low-resistance contact piece (9, 10), in which arrangement the two contact pieces (9, 10) rest on associated metallisation tracks (4, 5) of the support body (6) and are electrically conductively connected to the latter and in which arrangement, furthermore, the support body (6) has a recess (8) in the area of the diode stack (1) so that the diode stack (1) is only connected to the support body (6) by means of the two contact pieces (9, 10) which are attached to its front ends, characterized in that the electrically conductive connection between the two contact pieces (9, 10) attached to the diode stack (1) and the associated metallisation tracks (4, 5) of the support body (6) is formed by an electrically conductive adhesive (16) extending between these parts (9 and 4 or 10 and 5, respectively) and that the diode stack (1) is enclosed by a passivation paint (17), the baking temperature of which is at least approximately equal to the baking temperature of the electrically conductive adhesive (16).

2. Diode arrangement according to Claim 1, characterized in that the electrically conductive adhesive (16) extends past the area of rest of the contact pieces (9, 10) over the entire surface of the contact pieces (9, 10) with the exception of the front end facing the diode stack (1), via which front face the contact pieces (9, 10) are electrically conductively connected to the diode stack (1).

3. Diode arrangement according to Claim 1 or 2, characterized in that the front end facing the diode stack (1) and the front face of the contact pieces (9, 10) opposite it in each case carry a metallisation (11, 13; 12, 14).

4. Diode arrangement according to one of Claims 1 to 3, characterized in that n-type or p-type silicon pieces with a thickness of several millimetres are used as lower-resistance contact pieces (9, 10) and in that the metallisations (11, 13; 12, 14) consist of aluminium.

5. Diode arrangement according to one of the preceding claims, characterized in that the front ends (13, 14) of the diode stack (1) are additionally provided with a nickel and a gold layer.

6. Diode arrangement according to one of the preceding claims, characterized in that the low-resistance contact pieces (9, 10) and the diode stack (1) are connected to one another by being soldered together.

7. Diode arrangement according to one of Claims 1, 2, 3, 5 and 6, characterized in that the low-resistance contact pieces (9, 10) consist of metal, for example of molybdenum.